# EUROPEAN PATENT APPLICATION

(11) **EP 4 734 716 A1**
(43) Date of publication of application: **29.04.2026**
(21) Application number: 23949819.9
(22) Date of filing: 22.08.2023
(51) Int. Cl.: H10H 20/841, H10H 20/857, H01H 29/20, G09F 9/30

(54) **LIGHT-EMITTING DIODE, DISPLAY DEVICE USING SAME, AND MANUFACTURING METHOD THEREFOR**

(71) Applicant: LG Electronics Inc., Yeongdeungpo-gu Seoul 07336 (KR)
(72) Inventor: HEO, Mihee, Seoul 06772 (KR); SUNG, Junho, Seoul 06772 (KR); MOON, Seongmin, Seoul 06772 (KR)
(74) Representative: Vossius & Partner Patentanwälte Rechtsanwälte mbB
(86) International application number: PCT/KR2023/012412
(87) International publication number: WO 2025/041879

(57) **Abstract**

The present disclosure is applicable to the technical field related to display devices, and relates to, for example, a micro light-emitting diode (LED), a display device using same, and a manufacturing method therefor. The present disclosure may include: a first conductivity type semiconductor layer; a second conductivity type semiconductor layer; an active layer positioned between the first conductivity type semiconductor layer and the second conductivity type semiconductor layer; a first contact layer at least a portion of which is discontinuously and electrically connected to a first surface of the first conductivity type semiconductor layer; and a reflective layer positioned on the first contact layer.

## Description

### [Technical Field]

The present disclosure is applicable to a technical field related to display devices, and relates to, for example, a micro light emitting diode (LED), a display device using the same, and a method for manufacturing the same.

### [Background]

Recently, in a field of a display technology, display devices having excellent characteristics such as thinness, flexibility, and the like have been developed. On the other hand, currently commercialized major displays are represented by a LCD (liquid crystal display) and an OLED (organic light emitting diode).

However, LCDs have problems in that response times are not short and flexible implementation is difficult, and OLEDs have problems in that lifespans are short and mass production yields are not good.

On the other hand, LED (light emitting diode), which is a well-known semiconductor light emitting element that converts electric current into light, has been used as a light source for a display image of an electronic device including an information and communication device along with a GaP:N-based green LED, starting with commercialization of a red LED using a GaAsP compound semiconductor in 1962. Accordingly, a method for solving the above-described problems by implementing a display using the semiconductor light emitting element may be proposed. Such light emitting diode has various advantages, such as long lifespan, low power consumption, excellent initial driving characteristics, high vibration resistance, and the like, compared to a filament-based light emitting element.

AuGe alloy metals, which are commonly used for electrical characteristics of n-type electrodes, have low reflectivity. Moreover, the reflectivity of AuGe alloys is reduced to a level of about 20% after heat treatment for forming ohmic contacts.

Various metal layer structures have been attempted to solve such a problem, but it is difficult to satisfy both electrical and optical characteristics at the same time.

To solve such a problem, a form in which an ohmic contact is partially formed and a reflective film is formed on a remaining portion has also been proposed. However, because light emitting element chips have a size on a micro-scale, there is a difficulty in structural implementation.

In addition, a reflective film covering an entire n-type semiconductor layer in an alloy form has also been proposed, but reflection efficiency may be lowered compared to that of a single metal.

In addition, in particular, a gold (Au) reflective film mainly used in red light emitting elements has a high manufacturing cost, and causes inter-diffusion with aluminum (Al) used as a bridge metal in a display device, thereby forming non-uniform inter-metallic compound (IMC).

Kirkendall voids may be formed in an Au-rich region due to a high diffusion rate at such an Al-Au interface. Such voids not only increase resistance by reducing an area through which current may flow, but also cause reliability issues in the long run.

Therefore, there is a need for a method capable of solving such problems.

### [Summary]

### [Technical Problem]

The present disclosure is intended to provide a light emitting element, a display device using the same, and a method for manufacturing the same in which light extraction efficiency of the light emitting element may be improved and thus efficiency of the display device may also be improved together.

In addition, the present disclosure is intended to provide a light emitting element, a display device using the same, and a method for manufacturing the same in which light extraction efficiency of a red light emitting element may be improved and thus efficiency of the display device may also be improved together.

In addition, the present disclosure is intended to provide a light emitting element, a display device using the same, and a method for manufacturing the same in which reflectance as well as ohmic contact characteristics of the light emitting element may be improved together.

Further, the present disclosure is intended to provide a light emitting element, a display device using the same, and a method for manufacturing the same capable of solving problems related to panel reliability (e.g., increase in resistance, weakness, degradation, and the like) that may be caused by a non-uniform alloy that may occur when a connection electrode is formed in a panel process.

Furthermore, an embodiment of the present disclosure is to solve various problems not mentioned herein. Such problems will be understood by those skilled in the art from the overall disclosure of the present document and the drawings.

### [Technical Solutions]

As a first aspect to solve the above problems, the present disclosure provides a light emitting element comprising: a first conductivity-type semiconductor layer; a second conductivity-type semiconductor layer; an active layer disposed between the first conductivity-type semiconductor layer and the second conductivity-type semiconductor layer; a first contact layer having at least a portion electrically connected to a first surface of the first conductivity-type semiconductor layer in a discontinous manner; and a reflective layer disposed on the first contact layer.

In one implementation of the first aspect, the first contact layer may form an ohmic contact with the first conductivity-type semiconductor layer at a portion that is electrically connected to the first surface in a discontinous manner.

In one implementation of the first aspect, the ohmic contact may be formed by diffusion of at least a portion of the first contact layer into the first conductivity-type semiconductor layer.

In one implementation of the first aspect, the first contact layer may include: a first metal forming an ohmic contact with the first conductivity-type semiconductor layer; and a second metal for diffusing the first metal.

In one implementation of the first aspect, the first metal and the second metal may form an alloy.

In one implementation of the first aspect, the first metal may include a region diffused into the first conductivity-type semiconductor layer.

In one implementation of the first aspect, an interface may exist between the first contact layer and the reflective layer.

In one implementation of the first aspect, the reflective layer may be a single metal layer including Ag.

In one implementation of the first aspect, the first metal may include Ge, and the second metal may include Au.

In one implementation of the first aspect, the light emitting element may further comprise a magnetic layer disposed on the reflective layer.

In one implementation of the first aspect, the light emitting element may further comprise a second contact layer positioned on a second surface opposite to the first surface with respect to the active layer, and electrically connected to the first conductivity-type semiconductor layer.

In one implementation of the first aspect, the first contact layer may occupy an area of 5 to 20% of a total area of the first surface.

As a second aspect to solve the above problems, the present disclosure provides a method for manufacturing a light emitting element including a semiconductor layer including a first conductivity-type semiconductor layer, a second conductivity-type semiconductor layer, and an active layer disposed between the first conductivity-type semiconductor layer and the second conductivity-type semiconductor layer, the method comprising: forming a first contact layer on the first conductivity-type semiconductor layer; and forming a reflective layer on a first metal layer, wherein the forming of the first contact layer includes: forming a first layer where a first metal and a second metal form an alloy on the first conductivity-type semiconductor layer; forming a second layer including the second metal on the first layer; performing heat treatment on the first layer; and removing the second layer.

In one implementation of the second aspect, the forming of the first contact layer may include: forming a photoresist layer opening a first surface of the first conductivity-type semiconductor layer; continuously forming the first layer and the second layer on the first surface; and removing the photoresist.

In one implementation of the second aspect, the forming of the first contact layer may be performed while the second conductivity-type semiconductor layer is attached to a transfer substrate through a sacrificial layer.

In one implementation of the second aspect, the method may further comprise forming a reflective layer on a surface from which the second layer has been removed.

In one implementation of the second aspect, the method may further comprise forming a magnetic layer on the reflective layer.

As a third aspect to solve the above problems, the present disclosure provides a display device using a semiconductor light emitting element, the display device comprising: a wiring substrate where a first electrode is disposed; a light emitting element including a semiconductor layer disposed on the wiring substrate to form a unit sub-pixel; a first connection electrode electrically connecting the first electrode to one side of the semiconductor layer of the light emitting element; a planarization layer covering the light emitting element and the first connection electrode; and a second connection electrode positioned on the planarization layer and electrically connected to an opposite side of the semiconductor layer of the light emitting element, wherein the light emitting element includes: a first contact layer having at least a portion electrically connected to a first surface of the semiconductor layer in a discontinous manner; and a reflective layer disposed on the first contact layer.

### [Advantageous Effects]

According to an embodiment of the present disclosure, there are the following effects.

First, according to an embodiment of the present disclosure, a metal for an ohmic contact may be formed on a partial region of the light emitting element having a vertical structure, and a high-reflection metal may be formed on the remaining region, thereby improving light extraction efficiency of the light emitting element.

The first contact layer may add a rough surface to the bottom surface (the first surface) of the first conductivity-type semiconductor layer, thereby additionally improving efficiency of extracting light through the first surface.

Because such a first contact layer mainly affects the formation of an ohmic contact and a rough surface, consumption of a material (particularly, gold (Au)) for forming the first contact layer may be greatly reduced.

Because the reflective layer is made of a single metal without additional heat treatment, a reduction in reflectance due to formation of an alloy with a surrounding material by a heat treatment process may not occur.

Further, problems related to panel reliability (e.g., increase in resistance, weakness, degradation, and the like), which may be caused by a non-uniform Au-Al alloy, that may occur when the connection electrode is formed in a panel process may be solved.

Furthermore, according to another embodiment of the present disclosure, there are additional effects not mentioned herein. Such additional effects will be understood by those skilled in the art from the overall disclosure of the present document and the drawings.

### [Brief Description of the Drawings]

FIG. 1 is a conceptual diagram illustrating an embodiment of a display device using a semiconductor light emitting element according to the present disclosure.
FIG. 2 is a partially enlarged diagram showing a part A shown in FIG. 1.
FIGS. 3A and 3B are cross-sectional diagrams taken along the cutting lines B-B and C-C in FIG. 2.
FIG. 4 is a conceptual diagram illustrating the flip-chip type semiconductor light emitting element of FIGS. 3A and 3B.
FIGS. 5A to 5C are conceptual diagrams illustrating various examples of color implementation with respect to a flip-chip type semiconductor light emitting element.
FIG. 6 shows cross-sectional views of a method of fabricating a display device using a semiconductor light emitting element according to the present disclosure.
FIG. 7 is a perspective diagram of a display device using a semiconductor light emitting element according to another embodiment of the present disclosure.
FIG. 8 is a cross-sectional diagram taken along a cutting line D-D shown in FIG. 8.
FIG. 9 is a conceptual diagram showing a vertical type semiconductor light emitting element shown in FIG. 8.
FIG. 10 is a cross-sectional view showing a light emitting element according to an embodiment of the present disclosure.
FIG. 11 is a graph showing reflectance according to wavelengths of metals that may be used as a reflective layer.
FIGS. 12 to 19 are views for illustrating a process of manufacturing a light emitting element according to an embodiment of the present disclosure.
FIGS. 20 and 21 are photographs and analysis photographs showing examples in which a first contact layer is formed.
FIG. 22 is a cross-sectional view showing a display device using a light emitting element according to an embodiment of the present disclosure.

### [Best Mode]

Reference will now be made in detail to embodiments of the present disclosure, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical spirit disclosed in the present specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

The display device described herein is a concept including all display devices that display information with a unit pixel or a set of unit pixels. Therefore, the display device may be applied not only to finished products but also to parts. For example, a panel corresponding to a part of a digital TV also independently corresponds to the display device in the present specification. The finished products include a mobile phone, a smartphone, a laptop, a digital broadcasting terminal, a personal digital assistant (PDA), a portable multimedia player (PMP), a navigation system, a slate PC, a tablet, an Ultrabook, a digital TV, a desktop computer, and the like.

However, it will be readily apparent to those skilled in the art that the configuration according to the embodiments described herein is applicable even to a new product that will be developed later as a display device.

In addition, the semiconductor light emitting element mentioned in this specification is a concept including an LED, a micro LED, and the like, and may be used interchangeably therewith.

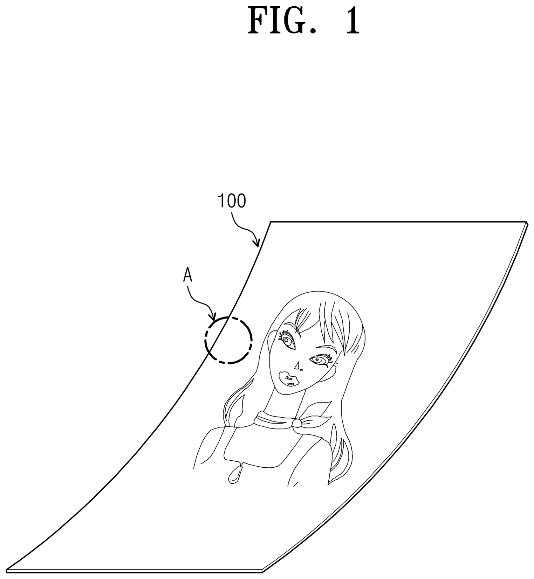

FIG. 1 is a conceptual view illustrating an embodiment of a display device using a semiconductor light emitting element according to the present disclosure.

As shown in FIG. 1, information processed by a controller (not shown) of a display device 100 may be displayed using a flexible display.

The flexible display may include, for example, a display that can be warped, bent, twisted, folded, or rolled by external force.

Furthermore, the flexible display may be, for example, a display manufactured on a thin and flexible substrate that can be warped, bent, folded, or rolled like paper while maintaining the display characteristics of a conventional flat panel display.

When the flexible display remains in an unbent state (e.g., a state having an infinite radius of curvature) (hereinafter referred to as a first state), the display area of the flexible display forms a flat surface. When the display in the first sate is changed to a bent state (e.g., a state having a finite radius of curvature) (hereinafter referred to as a second state) by external force, the display area may be a curved surface. As shown in FIG. 1, the information displayed in the second state may be visual information output on a curved surface. Such visual information may be implemented by independently controlling the light emission of sub-pixels arranged in a matrix form. The unit pixel may mean, for example, a minimum unit for implementing one color.

The unit pixel of the flexible display may be implemented by a semiconductor light emitting element. In the present disclosure, a light emitting diode (LED) is exemplified as a type of the semiconductor light emitting element configured to convert electric current into light. The LED may be formed in a small size, and may thus serve as a unit pixel even in the second state.

Hereinafter, a flexible display implemented using the LED will be described in more detail with reference to the drawings.

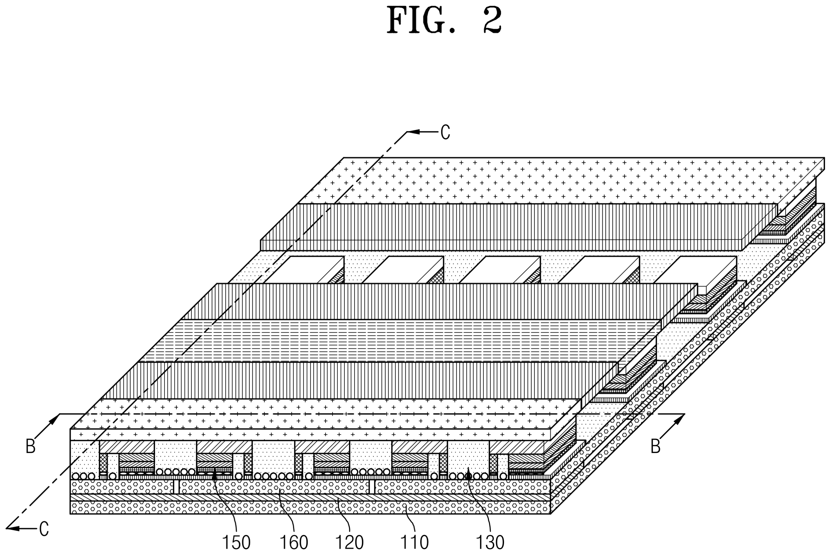

FIG. 2 is a partially enlarged view showing part A of FIG. 1.

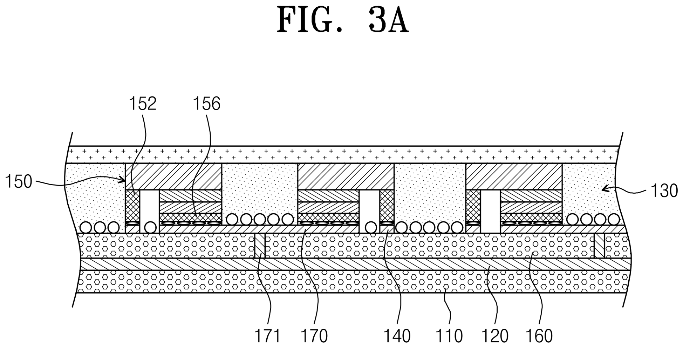

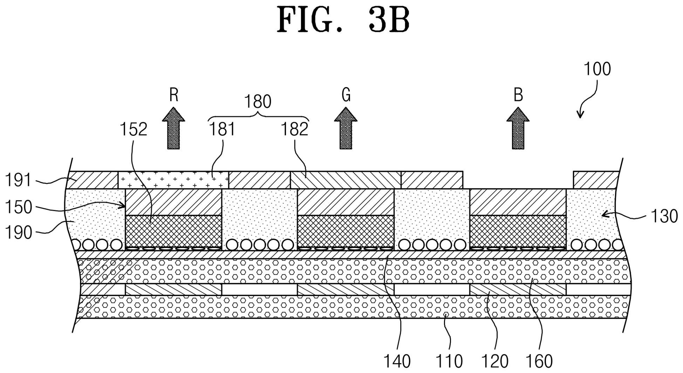

FIGS. 3A and 3B are cross-sectional views taken along lines B-B and C-C in FIG. 2.

As shown in FIGS. 2, 3A and 3B, the display device 100 using a passive matrix (PM) type semiconductor light emitting element is exemplified as the display device 100 using a semiconductor light emitting element. However, the examples described below are also applicable to an active matrix (AM) type semiconductor light emitting element.

The display device 100 shown in FIG. 1 may include a substrate 110, a first electrode 120, a conductive adhesive layer 130, a second electrode 140, and at least one semiconductor light emitting element 150, as shown in FIG. 2.

The substrate 110 may be a flexible substrate. For example, to implement a flexible display device, the substrate 110 may include glass or polyimide (PI). Any insulative and flexible material such as polyethylene naphthalate (PEN) or polyethylene terephthalate (PET) may be employed. In addition, the substrate 110 may be formed of either a transparent material or an opaque material.

The substrate 110 may be a wiring substrate on which the first electrode 120 is disposed. Thus, the first electrode 120 may be positioned on the substrate 110.

As shown in FIG. 3A, an insulating layer 160 may be disposed on the substrate 110 on which the first electrode 120 is positioned, and an auxiliary electrode 170 may be positioned on the insulating layer 160. In this case, a stack in which the insulating layer 160 is laminated on the substrate 110 may be a single wiring substrate. More specifically, the insulating layer 160 may be formed of an insulative and flexible material such as PI, PET, or PEN, and may be integrated with the substrate 110 to form a single substrate.

The auxiliary electrode 170, which is an electrode that electrically connects the first electrode 120 and the semiconductor light emitting element 150, is positioned on the insulating layer 160, and is disposed to correspond to the position of the first electrode 120. For example, the auxiliary electrode 170 may have a dot shape and may be electrically connected to the first electrode 120 by an electrode hole 171 formed through the insulating layer 160. The electrode hole 171 may be formed by filling a via hole with a conductive material.

As shown in FIGS. 2 or 3A, a conductive adhesive layer 130 may be formed on one surface of the insulating layer 160, but embodiments of the present disclosure are not limited thereto. For example, a layer performing a specific function may be formed between the insulating layer 160 and the conductive adhesive layer 130, or the conductive adhesive layer 130 may be disposed on the substrate 110 without the insulating layer 160. In a structure in which the conductive adhesive layer 130 is disposed on the substrate 110, the conductive adhesive layer 130 may serve as an insulating layer.

The conductive adhesive layer 130 may be a layer having adhesiveness and conductivity. For this purpose, a material having conductivity and a material having adhesiveness may be mixed in the conductive adhesive layer 130. In addition, the conductive adhesive layer 130 may have ductility, thereby providing making the display device flexible.

As an example, the conductive adhesive layer 130 may be an anisotropic conductive film (ACF), an anisotropic conductive paste, a solution containing conductive particles, or the like. The conductive adhesive layer 130 may be configured as a layer that allows electrical interconnection in the direction of the Z-axis extending through the thickness, but is electrically insulative in the horizontal X-Y direction. Accordingly, the conductive adhesive layer 130 may be referred to as a Z-axis conductive layer (hereinafter, referred to simply as a "conductive adhesive layer").

The ACF is a film in which an anisotropic conductive medium is mixed with an insulating base member. When the ACF is subjected to heat and pressure, only a specific portion thereof becomes conductive by the anisotropic conductive medium. Hereinafter, it will be described that heat and pressure are applied to the ACF. However, another method may be used to make the ACF partially conductive. The other method may be, for example, application of only one of the heat and pressure or UV curing.

In addition, the anisotropic conductive medium may be, for example, conductive balls or conductive particles. For example, the ACF may be a film in which conductive balls are mixed with an insulating base member. Thus, when heat and pressure are applied to the ACF, only a specific portion of the ACF is allowed to be conductive by the conductive balls. The ACF may contain a plurality of particles formed by coating the core of a conductive material with an insulating film made of a polymer material. In this case, as the insulating film is destroyed in a portion to which heat and pressure are applied, the portion is made to be conductive by the core. At this time, the cores may be deformed to form layers that contact each other in the thickness direction of the film. As a more specific example, heat and pressure are applied to the whole ACF, and an electrical connection in the Z-axis direction is partially formed by the height difference of a counterpart adhered by the ACF.

As another example, the ACF may contain a plurality of particles formed by coating an insulating core with a conductive material. In this case, as the conductive material is deformed (pressed) in a portion to which heat and pressure are applied, the portion is made to be conductive in the thickness direction of the film. As another example, the conductive material may be disposed through the insulating base member in the Z-axis direction to provide conductivity in the thickness direction of the film. In this case, the conductive material may have a pointed end.

The ACF may be a fixed array ACF in which conductive balls are inserted into one surface of the insulating base member. More specifically, the insulating base member may be formed of an adhesive material, and the conductive balls may be intensively disposed on the bottom portion of the insulating base member. Thus, when the base member is subjected to heat and pressure, it may be deformed together with the conductive balls, exhibiting conductivity in the vertical direction.

However, the present disclosure is not necessarily limited thereto, and the ACF may be formed by randomly mixing conductive balls in the insulating base member, or may be composed of a plurality of layers with conductive balls arranged on one of the layers (as a double- ACF).

The anisotropic conductive paste may be a combination of a paste and conductive balls, and may be a paste in which conductive balls are mixed with an insulating and adhesive base material. Also, the solution containing conductive particles may be a solution containing any conductive particles or nanoparticles.

Referring back to FIG. 3A, the second electrode 140 is positioned on the insulating layer 160 and spaced apart from the auxiliary electrode 170. That is, the conductive adhesive layer 130 is disposed on the insulating layer 160 having the auxiliary electrode 170 and the second electrode 140 positioned thereon.

After the conductive adhesive layer 130 is formed with the auxiliary electrode 170 and the second electrode 140 positioned on the insulating layer 160, the semiconductor light emitting element 150 is connected thereto in a flip-chip form by applying heat and pressure. Thereby, the semiconductor light emitting element 150 is electrically connected to the first electrode 120 and the second electrode 140.

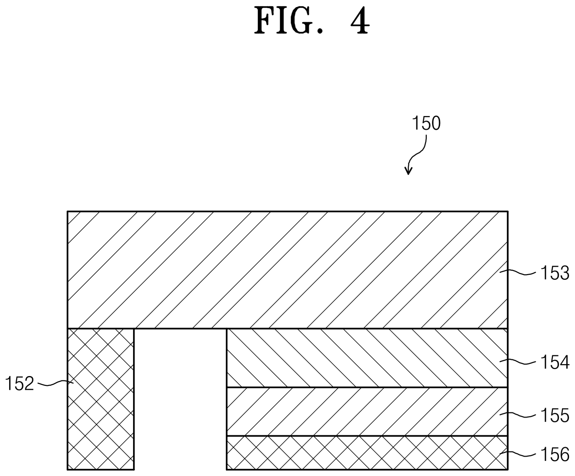

FIG. 4 is a conceptual view illustrating the flip-chip type semiconductor light emitting element of FIGS. 3A and 3B.

Referring to FIG. 4, the semiconductor light emitting element may be a flip chip-type light emitting device.

For example, the semiconductor light emitting element may include a p-type electrode 156, a p-type semiconductor layer 155 on which the p-type electrode 156 is formed, an active layer 154 formed on the p-type semiconductor layer 155, an n-type semiconductor layer 153 formed on the active layer 154, and an n-type electrode 152 disposed on the n-type semiconductor layer 153 and horizontally spaced apart from the p-type electrode 156. In this case, the p-type electrode 156 may be electrically connected to the auxiliary electrode 170, which is shown in FIGS. 3A and 3B, by the conductive adhesive layer 130, and the n-type electrode 152 may be electrically connected to the second electrode 140.

Referring back to FIGS. 2, 3A and 3B, the auxiliary electrode 170 may be elongated in one direction. Thus, one auxiliary electrode may be electrically connected to the plurality of semiconductor light emitting elements 150. For example, p-type electrodes of semiconductor light emitting elements on left and right sides of an auxiliary electrode may be electrically connected to one auxiliary electrode.

More specifically, the semiconductor light emitting element 150 may be press-fitted into the conductive adhesive layer 130 by heat and pressure. Thereby, only the portions of the semiconductor light emitting element 150 between the p-type electrode 156 and the auxiliary electrode 170 and between the n-type electrode 152 and the second electrode 140 may exhibit conductivity, and the other portions of the semiconductor light emitting element 150 do not exhibit conductivity as they are not press-fitted. In this way, the conductive adhesive layer 130 interconnects and electrically connects the semiconductor light emitting element 150 and the auxiliary electrode 170 and interconnects and electrically connects the semiconductor light emitting element 150 and the second electrode 140.

The plurality of semiconductor light emitting elements 150 may constitute a light emitting device array, and a phosphor conversion layer 180 may be formed on the light emitting device array.

The light emitting device array may include a plurality of semiconductor light emitting elements having different luminance values. Each semiconductor light emitting element 150 may constitute a unit pixel and may be electrically connected to the first electrode 120. For example, a plurality of first electrodes 120 may be provided, and the semiconductor light emitting elements may be arranged in, for example, several columns. The semiconductor light emitting elements in each column may be electrically connected to any one of the plurality of first electrodes.

In addition, since the semiconductor light emitting elements are connected in a flip-chip form, semiconductor light emitting elements grown on a transparent dielectric substrate may be used. The semiconductor light emitting elements may be, for example, nitride semiconductor light emitting elements. Since the semiconductor light emitting element 150 has excellent luminance, it may constitute an individual unit pixel even when it has a small size.

As shown in FIG. 3, a partition 190 may be formed between the semiconductor light emitting elements 150. In this case, the partition 190 may serve to separate individual unit pixels from each other, and may be integrated with the conductive adhesive layer 130. For example, by inserting the semiconductor light emitting element 150 into the ACF, the base member of the ACF may form the partition.

In addition, when the base member of the ACF is black, the partition 190 may have reflectance and increase contrast even without a separate black insulator.

As another example, a reflective partition may be separately provided as the partition 190. In this case, the partition 190 may include a black or white insulator depending on the purpose of the display device. When a partition including a white insulator is used, reflectivity may be increased. When a partition including a black insulator is used, it may have reflectance and increase contrast.

The phosphor conversion layer 180 may be positioned on the outer surface of the semiconductor light emitting element 150. For example, the semiconductor light emitting element 150 may be a blue semiconductor light emitting element that emits blue (B) light, and the phosphor conversion layer 180 may function to convert the blue (B) light into a color of a unit pixel. The phosphor conversion layer 180 may be a red phosphor 181 or a green phosphor 182 constituting an individual pixel.

That is, the red phosphor 181 capable of converting blue light into red (R) light may be laminated on a blue semiconductor light emitting element at a position of a unit pixel of red color, and the green phosphor 182 capable of converting blue light into green (G) light may be laminated on the blue semiconductor light emitting element at a position of a unit pixel of green color. Only the blue semiconductor light emitting element may be used alone in the portion constituting the unit pixel of blue color. In this case, unit pixels of red (R), green (G), and blue (B) may constitute one pixel. More specifically, a phosphor of one color may be laminated along each line of the first electrode 120. Accordingly, one line on the first electrode 120 may be an electrode for controlling one color. That is, red (R), green (G), and blue (B) may be sequentially disposed along the second electrode 140, thereby implementing a unit pixel.

However, embodiments of the present disclosure are not limited thereto. Unit pixels of red (R), green (G), and blue (B) may be implemented by combining the semiconductor light emitting element 150 and the quantum dot (QD) rather than using the phosphor.

Also, a black matrix 191 may be disposed between the phosphor conversion layers to improve contrast. That is, the black matrix 191 may improve contrast of light and darkness.

However, embodiments of the present disclosure are not limited thereto, and another structure may be applied to implement blue, red, and green colors.

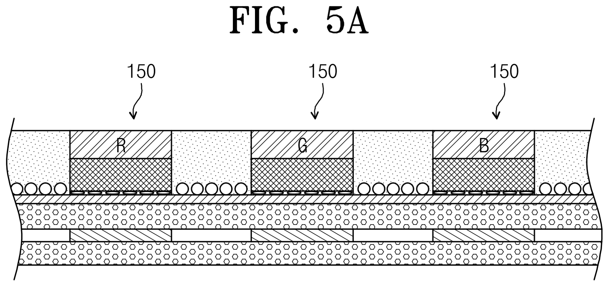

FIGS. 5A to 5C are conceptual views illustrating various examples of implementation of colors in relation to a flip-chip type semiconductor light emitting element.

Referring to FIG. 5A, each semiconductor light emitting element may be implemented as a high-power light emitting device emitting light of various colors including blue by using gallium nitride (GaN) as a main material and adding indium (In) and/or aluminum (Al).

In this case, each semiconductor light emitting element may be a red, green, or blue semiconductor light emitting element to form a unit pixel (sub-pixel). For example, red, green, and blue semiconductor light emitting elements R, G, and B may be alternately disposed, and unit pixels of red, green, and blue may constitute one pixel by the red, green and blue semiconductor light emitting elements. Thereby, a full-color display may be implemented.

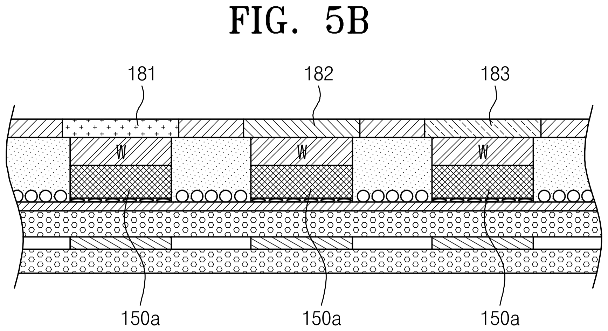

Referring to FIG. 5B, the semiconductor light emitting element 150a may include a white light emitting device W having a yellow phosphor conversion layer, which is provided for each device. In this case, in order to form a unit pixel, a red phosphor conversion layer 181, a green phosphor conversion layer 182, and a blue phosphor conversion layer 183 may be disposed on the white light emitting device W. In addition, a unit pixel may be formed using a color filter repeating red, green, and blue on the white light emitting device W.

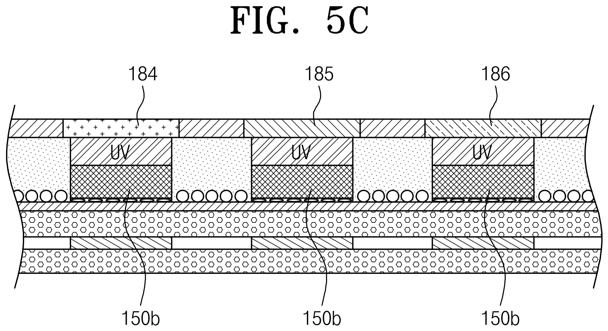

Referring to FIG. 5C, a red phosphor conversion layer 184, a green phosphor conversion layer 185, and a blue phosphor conversion layer 186 may be provided on a ultraviolet light emitting device. Not only visible light but also ultraviolet (UV) light may be used in the entire region of the semiconductor light emitting element. In an embodiment, UV may be used as an excitation source of the upper phosphor in the semiconductor light emitting element.

Referring back to this example, the semiconductor light emitting element is positioned on the conductive adhesive layer to constitute a unit pixel in the display device. Since the semiconductor light emitting element has excellent luminance, individual unit pixels may be configured despite even when the semiconductor light emitting element has a small size.

Regarding the size of such an individual semiconductor light emitting element, the length of each side of the device may be, for example, 80 µm or less, and the device may have a rectangular or square shape. When the semiconductor light emitting element has a rectangular shape, the size thereof may be less than or equal to 20 µm x 80 µm.

In addition, even when a square semiconductor light emitting element having a side length of 10 µm is used as a unit pixel, sufficient brightness to form a display device may be obtained.

Therefore, for example, in case of a rectangular pixel having a unit pixel size of 600 *µ*m x 300 *µ*m (i.e., one side by the other side), a distance of a semiconductor light emitting element becomes sufficiently long relatively.

Thus, in this case, it is able to implement a flexible display device having high image quality over HD image quality.

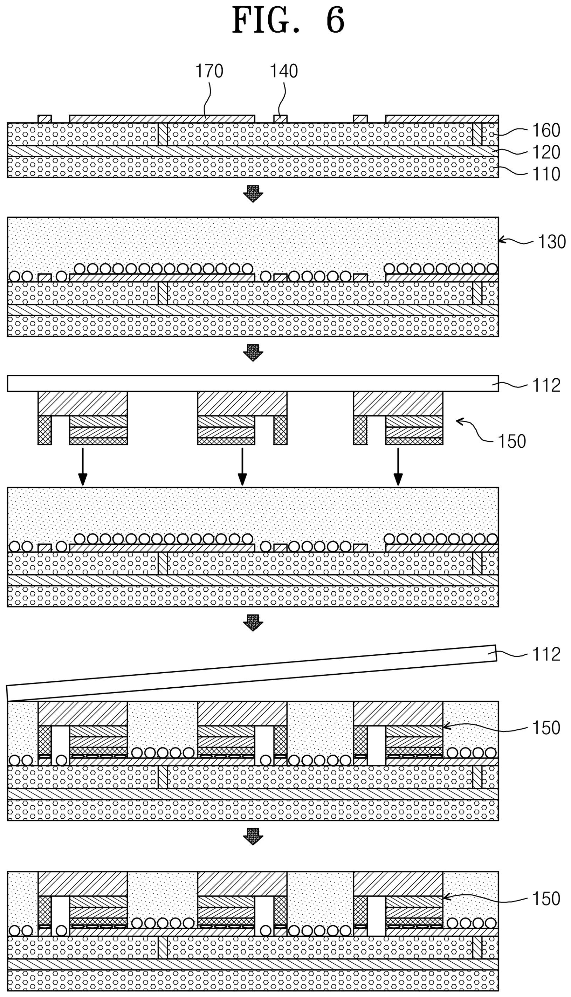

The above-described display device using the semiconductor light emitting element may be prepared by a new fabricating method. Such a fabricating method will be described with reference to FIG. 6 as follows.

FIG. 6 shows cross-sectional views of a method of fabricating a display device using a semiconductor light emitting element according to the present disclosure.

Referring to FIG. 6, first of all, a conductive adhesive layer 130 is formed on an insulating layer 160 located between an auxiliary electrode 170 and a second electrode 140. The insulating layer 160 is tacked on a wiring substrate 110. On the wiring substrate 110, a first electrode 120, the auxiliary electrode 170 and the second electrode 140 are disposed. In this case, the first electrode 120 and the second electrode 140 may be disposed in mutually orthogonal directions, respectively. In order to implement a flexible display device, the wiring substrate 110 and the insulating layer 160 may include glass or polyimide (PI) each.

For example, the conductive adhesive layer 130 may be implemented by an anisotropic conductive film. To this end, an anisotropic conductive film may be coated on the substrate on which the insulating layer 160 is located.

Subsequently, a temporary substrate 112, on which a plurality of semiconductor light emitting elements 150 configuring individual pixels are located to correspond to locations of the auxiliary electrode 170 and the second electrodes 140, is disposed in a manner that the semiconductor light emitting element 150 confronts the auxiliary electrode 170 and the second electrode 140.

In this regard, the temporary 112 substrate 112 is a growing substrate for growing the semiconductor light emitting element 150 and may include a sapphire or silicon substrate.

The semiconductor light emitting element is configured to have a space and size for configuring a display device when formed in unit of wafer, thereby being effectively used for the display device.

Subsequently, the wiring substrate 110 and the temporary substrate 112 are thermally compressed together. By the thermocompression, the wiring substrate 110 and the temporary substrate 112 are bonded together. Owing to the property of an anisotropic conductive film having conductivity by thermocompression, only a portion among the semiconductor light emitting element 150, the auxiliary electrode 170 and the second electrode 140 has conductivity, via which the electrodes and the semiconductor light emitting element 150 may be connected electrically. In this case, the semiconductor light emitting element 150 is inserted into the anisotropic conductive film, by which a partition may be formed between the semiconductor light emitting elements 150.

Then the temporary substrate 112 is removed. For example, the temporary substrate 112 may be removed using Laser Lift-Off (LLO) or Chemical Lift-Off (CLO).

Finally, by removing the temporary substrate 112, the semiconductor light emitting elements 150 exposed externally. If necessary, the wiring substrate 110 to which the semiconductor light emitting elements 150 are coupled may be coated with silicon oxide (SiOx) or the like to form a transparent insulating layer (not shown).

In addition, a step of forming a phosphor layer on one side of the semiconductor light emitting element 150 may be further included. For example, the semiconductor light emitting element 150 may include a blue semiconductor light emitting element emitting Blue (B) light, and a red or green phosphor for converting the blue (B) light into a color of a unit pixel may form a layer on one side of the blue semiconductor light emitting element.

The above-described fabricating method or structure of the display device using the semiconductor light emitting element may be modified into various forms. For example, the above-described display device may employ a vertical semiconductor light emitting element.

Furthermore, a modification or embodiment described in the following may use the same or similar reference numbers for the same or similar configurations of the former example and the former description may apply thereto.

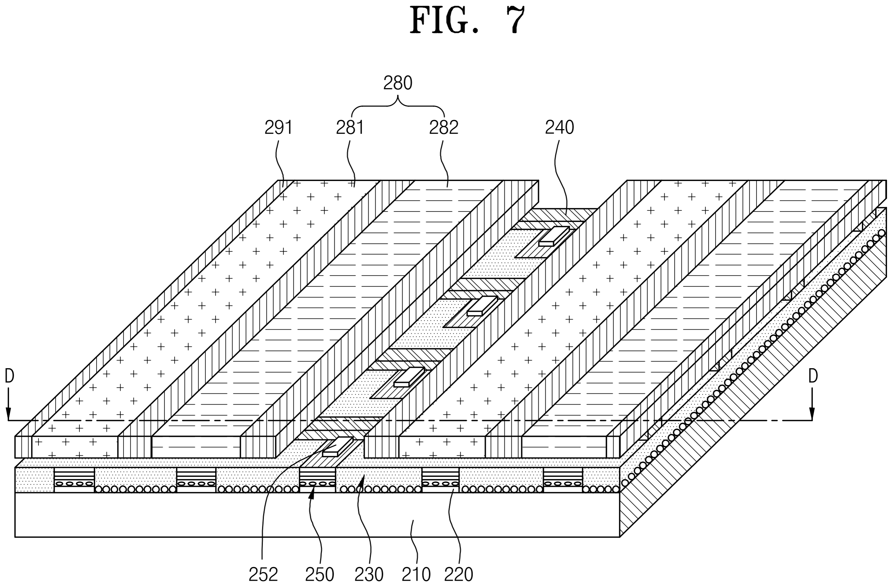

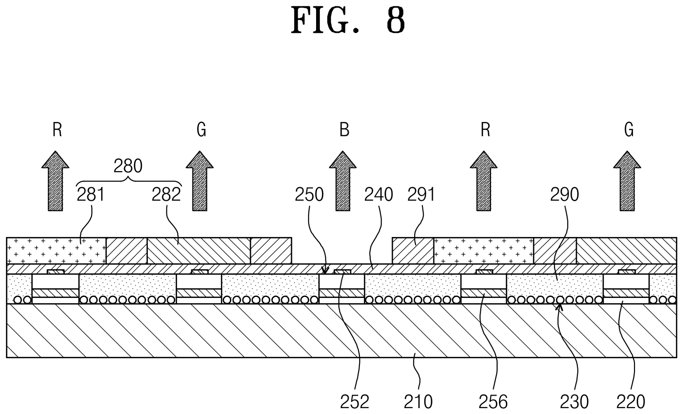

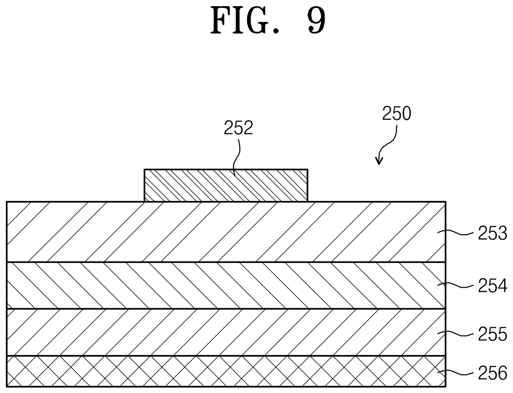

FIG. 7 is a perspective diagram of a display device using a semiconductor light emitting element according to another embodiment of the present disclosure, FIG. 8 is a cross-sectional diagram taken along a cutting line D-D shown in FIG. 8, and FIG. 9 is a conceptual diagram showing a vertical type semiconductor light emitting element shown in FIG. 8.

Referring to the present drawings, a display device may employ a vertical semiconductor light emitting device of a Passive Matrix (PM) type.

The display device includes a substrate 210, a first electrode 220, a conductive adhesive layer 230, a second electrode 240 and at least one semiconductor light emitting element 250.

The substrate 210 is a wiring substrate on which the first electrode 220 is disposed and may contain polyimide (PI) to implement a flexible display device. Besides, the substrate 210 may use any substance that is insulating and flexible.

The first electrode 210 is located on the substrate 210 and may be formed as a bar type electrode that is long in one direction. The first electrode 220 may be configured to play a role as a data electrode.

The conductive adhesive layer 230 is formed on the substrate 210 where the first electrode 220 is located. Like a display device to which a light emitting device of a flip chip type is applied, the conductive adhesive layer 230 may include one of an Anisotropic Conductive Film (ACF), an anisotropic conductive paste, a conductive particle contained solution and the like. Yet, in the present embodiment, a case of implementing the conductive adhesive layer 230 with the anisotropic conductive film is exemplified.

After the conductive adhesive layer has been placed in the state that the first electrode 220 is located on the substrate 210, if the semiconductor light emitting element 250 is connected by applying heat and pressure thereto, the semiconductor light emitting element 250 is electrically connected to the first electrode 220. In doing so, the semiconductor light emitting element 250 is preferably disposed to be located on the first electrode 220.

If heat and pressure is applied to an anisotropic conductive film, as described above, since the anisotropic conductive film has conductivity partially in a thickness direction, the electrical connection is established. Therefore, the anisotropic conductive film is partitioned into a conductive portion and a non-conductive portion.

Furthermore, since the anisotropic conductive film contains an adhesive component, the conductive adhesive layer 230 implements mechanical coupling between the semiconductor light emitting element 250 and the first electrode 220 as well as mechanical connection.

Thus, the semiconductor light emitting element 250 is located on the conductive adhesive layer 230, via which an individual pixel is configured in the display device. As the semiconductor light emitting element 250 has excellent luminance, an individual unit pixel may be configured in small size as well. Regarding a size of the individual semiconductor light emitting element 250, a length of one side may be equal to or smaller than 80 *µ*m for example and the individual semiconductor light emitting element 250 may include a rectangular or square element. For example, the rectangular element may have a size equal to or smaller than 20 *µ*m X 80 *µ*m.

The semiconductor light emitting element 250 may have a vertical structure.

Among the vertical type semiconductor light emitting elements, a plurality of second electrodes 240 respectively and electrically connected to the vertical type semiconductor light emitting elements 250 are located in a manner of being disposed in a direction crossing with a length direction of the first electrode 220.

Referring to FIG. 9, the vertical type semiconductor light emitting element 250 includes a p-type electrode 256, a p-type semiconductor layer 255 formed on the p-type electrode 256, an active layer 254 formed on the p-type semiconductor layer 255, an n-type semiconductor layer 253 formed on the active layer 254, and an n-type electrode 252 formed on then-type semiconductor layer 253. In this case, the p-type electrode 256 located on a bottom side may be electrically connected to the first electrode 220 by the conductive adhesive layer 230, and the n-type electrode 252 located on a top side may be electrically connected to a second electrode 240 described later. Since such a vertical type semiconductor light emitting element 250 can dispose the electrodes at top and bottom, it is considerably advantageous in reducing a chip size.

Referring to FIG. 8 again, a phosphor layer 280 may formed on one side of the semiconductor light emitting element 250. For example, the semiconductor light emitting element 250 may include a blue semiconductor light emitting element 251 emitting blue (B) light, and a phosphor layer 280 for converting the blue (B) light into a color of a unit pixel may be provided. In this regard, the phosphor layer 280 may include a red phosphor 281 and a green phosphor 282 configuring an individual pixel.

Namely, at a location of configuring a red unit pixel, the red phosphor 281 capable of converting blue light into red (R) light may be stacked on a blue semiconductor light emitting element. At a location of configuring a green unit pixel, the green phosphor 282 capable of converting blue light into green (G) light may be stacked on the blue semiconductor light emitting element. Moreover, the blue semiconductor light emitting element may be singly usable for a portion that configures a blue unit pixel. In this case, the unit pixels of red (R), green (G) and blue (B) may configure a single pixel.

Yet, the present disclosure is non-limited by the above description. In a display device to which a light emitting element of a flip chip type is applied, as described above, a different structure for implementing blue, red and green may be applicable.

Regarding the present embodiment again, the second electrode 240 is located between the semiconductor light emitting elements 250 and connected to the semiconductor light emitting elements electrically. For example, the semiconductor light emitting elements 250 are disposed in a plurality of columns, and the second electrode 240 may be located between the columns of the semiconductor light emitting elements 250.

Since a distance between the semiconductor light emitting elements 250 configuring the individual pixel is sufficiently long, the second electrode 240 may be located between the semiconductor light emitting elements 250.

The second electrode 240 may be formed as an electrode of a bar type that is long in one direction and disposed in a direction vertical to the first electrode.

In addition, the second electrode 240 and the semiconductor light emitting element 250 may be electrically connected to each other by a connecting electrode protruding from the second electrode 240. Particularly, the connecting electrode may include a n-type electrode of the semiconductor light emitting element 250. For example, the n-type electrode is formed as an ohmic electrode for ohmic contact, and the second electrode covers at least one portion of the ohmic electrode by printing or deposition. Thus, the second electrode 240 and the n-type electrode of the semiconductor light emitting element 250 may be electrically connected to each other.

Referring to FIG. 8 again, the second electrode 240 may be located on the conductive adhesive layer 230. In some cases, a transparent insulating layer (not shown) containing silicon oxide (SiOx) and the like may be formed on the substrate 210 having the semiconductor light emitting element 250 formed thereon. If the second electrode 240 is placed after the transparent insulating layer has been formed, the second electrode 240 is located on the transparent insulating layer. Alternatively, the second electrode 240 may be formed in a manner of being spaced apart from the conductive adhesive layer 230 or the transparent insulating layer.

If a transparent electrode of Indium Tin Oxide (ITO) or the like is sued to place the second electrode 240 on the semiconductor light emitting element 250, there is a problem that ITO substance has poor adhesiveness to an n-type semiconductor layer. Therefore, according to the present disclosure, as the second electrode 240 is placed between the semiconductor light emitting elements 250, it is advantageous in that a transparent electrode of ITO is not used. Thus, light extraction efficiency can be improved using a conductive substance having good adhesiveness to an n-type semiconductor layer as a horizontal electrode without restriction on transparent substance selection.

Referring to FIG. 8 again, a partition 290 may be located between the semiconductor light emitting elements 250. Namely, in order to isolate the semiconductor light emitting element 250 configuring the individual pixel, the partition 290 may be disposed between the vertical type semiconductor light emitting elements 250. In this case, the partition 290 may play a role in separating the individual unit pixels from each other and be formed with the conductive adhesive layer 230 as an integral part. For example, by inserting the semiconductor light emitting element 250 in an anisotropic conductive film, a base member of the anisotropic conductive film may form the partition.

In addition, if the base member of the anisotropic conductive film is black, the partition 290 may have reflective property as well as a contrast ratio may be increased, without a separate block insulator.

For another example, a reflective partition may be separately provided as the partition 190. The partition 290 may include a black or white insulator depending on the purpose of the display device.

In case that the second electrode 240 is located right onto the conductive adhesive layer 230 between the semiconductor light emitting elements 250, the partition 290 may be located between the vertical type semiconductor light emitting element 250 and the second electrode 240 each. Therefore, an individual unit pixel may be configured using the semiconductor light emitting element 250. Since a distance between the semiconductor light emitting elements 250 is sufficiently long, the second electrode 240 can be placed between the semiconductor light emitting elements 250. And, it may bring an effect of implementing a flexible display device having HD image quality.

In addition, as shown in FIG. 8, a black matrix 291 may be disposed between the respective phosphors for the contrast ratio improvement. Namely, the black matrix 291 may improve the contrast between light and shade.

In the display device using the semiconductor light emitting element according to the present disclosure described above, the semiconductor light emitting element is disposed on the wiring substrate in a flip chip type and used as an individual pixel.

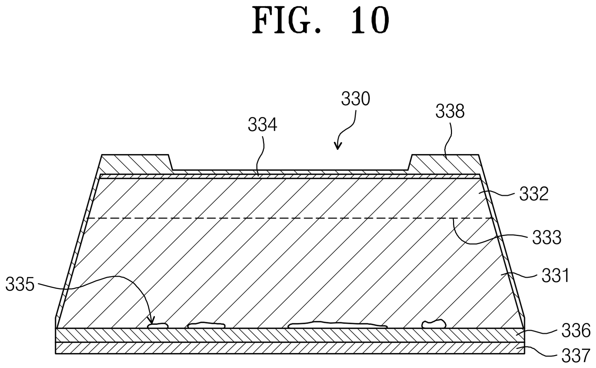

FIG. 10 is a cross-sectional view showing a light emitting element according to an embodiment of the present disclosure.

Referring to FIG. 10, a light emitting element 330 according to an embodiment of the present disclosure may include a semiconductor layer including a first conductivity-type semiconductor layer 331, a second conductivity-type semiconductor layer 332, and an active layer 333 disposed between the first conductivity-type semiconductor layer 331 and the second conductivity-type semiconductor layer 332. A horizontal cross-sectional shape of such a semiconductor layer may be one of a circular shape, an elliptical shape, and a polygonal shape.

For example, the first conductivity type may be an n-type. Accordingly, the second conductivity type may be a p-type. Hereinafter, an embodiment of the present disclosure will be described focusing on an example in which the first conductivity type is an n-type and the second conductivity type is a p-type. For example, the first conductivity-type semiconductor layer 331 may be an n-type semiconductor layer, and the second conductivity-type semiconductor layer 332 may be a p-type semiconductor layer. However, embodiments of the present disclosure are not limited thereto. That is, as another example, the first conductivity-type semiconductor layer 331 may be a p-type semiconductor layer, and the second conductivity-type semiconductor layer 332 may be an n-type semiconductor layer.

In an exemplary embodiment, the light emitting element may be a red light emitting element for emitting red light. Such a red light emitting element may include a GaAs or InP-based semiconductor. For example, the red light emitting element may include a compound semiconductor material composed of a combination of at least one of In, Ga, As, and P. However, embodiments of the present disclosure are not limited thereto.

In addition, the light emitting element 330 according to an embodiment of the present disclosure may include a first contact layer 335 at least a portion of which is discontinuously electrically connected in a discontinuous mannerto a first surface of the first conductivity-type semiconductor layer 331, and a reflective layer 336 positioned on the first contact layer 335.

As described above, the first contact layer 335 may be at least partially electrically connected to the first conductivity-type semiconductor layer 331. Here, the term "discontinuously" or "at least partially" may refer to a state in which the first contact layer 335 is discontinuously in contact with at least a portion of a bottom surface (the first surface), that is, a surface (the first surface) facing the reflective layer 336, of the first conductivity-type semiconductor layer 331 shown in FIG. 10.

For example, the first contact layer 335 may be positioned to be partially in ohmic contact with the first conductivity-type semiconductor layer 331 without covering the entire bottom surface (the first surface) of the first conductivity-type semiconductor layer 331. In this regard, because the reflective layer 336 is positioned on portions of the bottom surface (the first surface) of the first conductivity-type semiconductor layer 331 on which the first contact layer 335 is not positioned, reflectance of the light emitting element may be maintained without being significantly reduced by the first contact layer 335.

In an exemplary embodiment, the first contact layer 335 may occupy an area of 5 to 20% of a total area of the bottom surface (the first surface) of the first conductivity-type semiconductor layer 331.

A portion where the first contact layer 335 is in ohmic contact with the first conductivity-type semiconductor layer 331 may be a portion where at least a portion of the first contact layer 335 is diffused into the first conductivity-type semiconductor layer 331.

As an exemplary embodiment, the first contact layer 335 may include a first metal forming an ohmic contact with the first conductivity-type semiconductor layer 331, and a second metal for diffusing the first metal. For example, the first metal and the second metal may form an alloy.

As described above, the first metal constituting the first contact layer 335 may include a region (a diffused region) diffused into the first conductivity-type semiconductor layer 331.

As an example, the first metal may include Ge, and the second metal may include Au. For example, the first contact layer 335 may be formed of an alloy of gold (Au) and germanium (Ge). In other words, the first contact layer 335 may include an AuGe material.

In this regard, Ge may be diffused into the first conductivity-type semiconductor layer 331 to form an ohmic contact with the first conductivity-type semiconductor layer 331. Au may help Ge to evenly spread onto the first surface without clumping.

This will be described in detail later.

In an exemplary embodiment, an interface may exist between the first contact layer 335 and the reflective layer 336. For example, the first contact layer 335 and the reflective layer 336 may not be alloyed and may exist as individual layers.

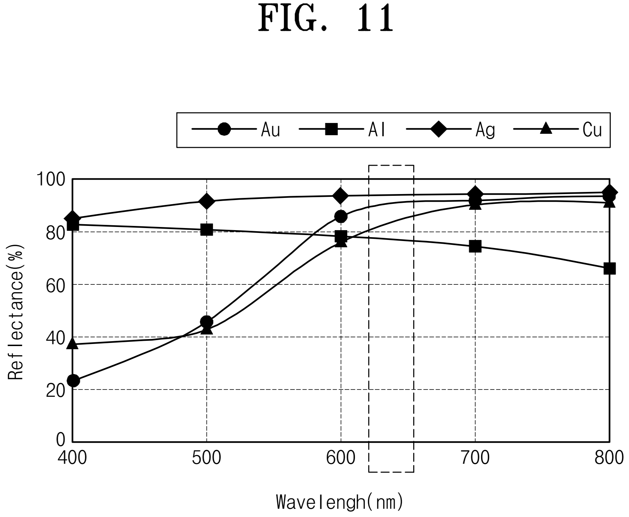

For example, the reflective layer 336 may form a single metal layer including silver (Ag). FIG. 11 is a graph showing reflectance according to wavelengths of metals that may be used as the reflective layer. Referring to FIG. 11, Ag may have relatively high reflectance with respect to red light. For example, Ag may have higher reflectance than gold (Au), aluminum (Al), and copper (Cu) with respect to red light, for example, light having a wavelength of 600nm or higher.

Ag has an alloy formation speed lower than that of Au, and has a characteristic of being uniformly formed. In addition, because Ag has thermal/electrical characteristics superior to those of Au, even when a contact area is small, current may flow easily without overheating, and voids are not formed. Therefore, Ag may be advantageous in terms of reliability.

As described above, the first contact layer 335 may be positioned in a relatively inner region of the bottom surface (the first surface) of the first conductivity-type semiconductor layer 331, and the reflective layer 336 may be positioned in a relatively outer region.

As an exemplary embodiment, the light emitting element 330 according to an embodiment of the present disclosure may further include a magnetic layer 337 disposed on the reflective layer 336.

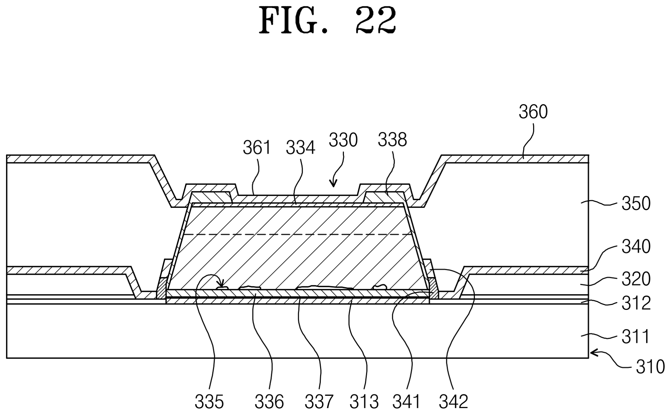

In order to be used as a sub-pixel of the display device, the light emitting element 330 may be assembled to a wiring substrate 310 (see FIG. 22) or a separate assembly substrate (not shown) using magnetic force. For example, the light emitting element 330 may be assembled using magnetic force in a fluid. Accordingly, the magnetic layer 337 may help the process of assembling the light emitting element 330 using magnetic force. A detailed description thereof will be omitted.

As an exemplary embodiment, the light emitting element 330 according to an embodiment of the present disclosure may further include a second contact layer 334 positioned on a second surface (a top surface) thereof opposite to the first surface (the bottom surface) with respect to the active layer 333 and electrically connected to the second conductivity-type semiconductor layer.

For example, the light emitting element 330 may include a passivation layer 338 for protecting an outer surface thereof from an electrical impact. Such a passivation layer 338 may be partially removed during the assembly process or a wiring connection process.

AuGe alloy metals, which are commonly used for electrical characteristics of n-type electrodes, have low reflectivity. Moreover, the reflectivity of AuGe alloys is reduced to a level of about 20% after heat treatment for forming ohmic contacts.

Various metal layer structures have been attempted to solve such a problem, but it is difficult to satisfy both electrical and optical characteristics at the same time.

To solve such a problem, a form in which an ohmic contact is partially formed and a reflective film is formed on a remaining portion has also been proposed. However, because light emitting element chips have a size on a micro-scale, there is a difficulty in structural implementation.

In addition, a reflective film covering an entire n-type semiconductor layer in an alloy form has also been proposed, but reflection efficiency may be lowered compared to that of a single metal.

In addition, in particular, a gold (Au) reflective film mainly used in red light emitting elements has a high manufacturing cost, and causes inter-diffusion with aluminum (Al) used as a bridge metal in a display device, thereby forming non-uniform inter-metallic compound (IMC).

Kirkendall voids may be formed in an Au-rich region due to a high diffusion rate at such an Al-Au interface. Such voids not only increase resistance by reducing an area through which current may flow, but also cause reliability issues in the long run.

However, according to such an exemplary embodiment of the present disclosure, as described above, metal (the first contact layer 335) for ohmic contact may be formed on a partial region of the bottom surface (the first surface) of the first conductivity-type semiconductor layer 331 for forming the n-contact of the light emitting element 330 having a vertical structure, and high-reflection metal (the reflective layer 336) may be formed on the remaining region, thereby improving light extraction efficiency of the light emitting element 330.

The first contact layer 335 may add a rough surface to the bottom surface (the first surface) of the first conductivity-type semiconductor layer 331 to additionally improve efficiency of extracting light through the first surface.

Because such a first contact layer 335 mainly affects the formation of an ohmic contact and a rough surface, consumption of a material (particularly, gold (Au)) for forming the first contact layer 335 may be greatly reduced.

Because the reflective layer 336 is made of a single metal without additional heat treatment, a reduction in reflectance due to formation of an alloy with a surrounding material by a heat treatment process may not occur.

Further, problems related to panel reliability (e.g., increase in resistance, weakness, degradation, and the like), which may be caused by a non-uniform Au-Al alloy, that may occur when a connection electrode 342 (see FIG. 22) is formed in a panel process may be solved.

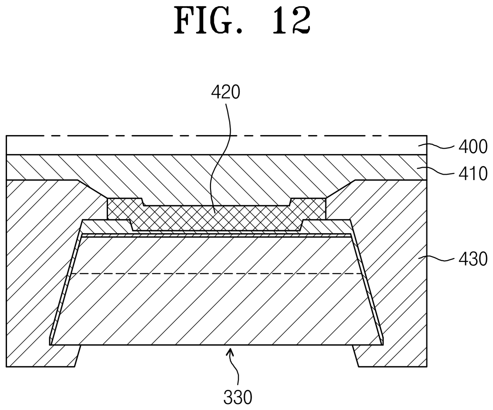

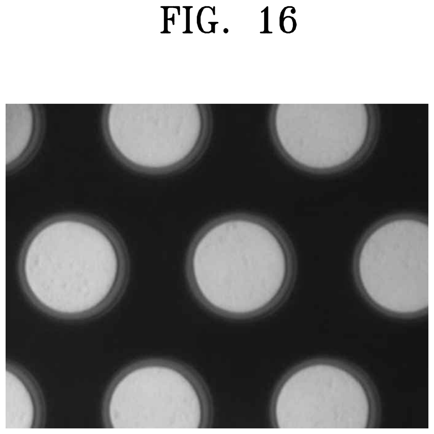

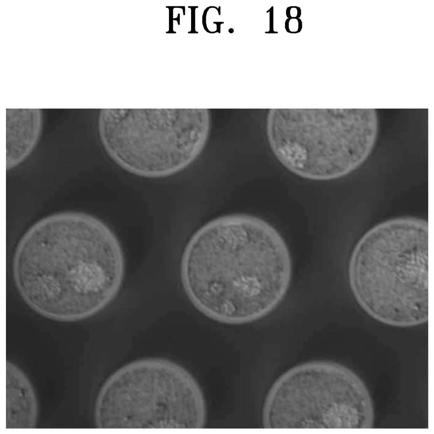

FIGS. 12 to 19 are views for illustrating a process of manufacturing a light emitting element according to an embodiment of the present disclosure. Among those, FIGS. 16 and 18 are photographs showing contact surfaces.

Hereinafter, a process of manufacturing the light emitting element 330 according to an embodiment of the present disclosure will be described in steps with reference to FIGS. 12 to 19.

First, referring to FIG. 12, the structure of the light emitting element 330 including the first conductivity-type semiconductor layer 331, the semiconductor layer including the second conductivity-type semiconductor layer 332, and the active layer 333 may be processed in a state of being attached to a transfer substrate 400 by a bonding layer 410.

For example, a sacrificial layer 420 may be positioned between the bonding layer 410 and the light emitting element 330. The sacrificial layer 420 is usually made of a metal material, and the light emitting element 330 may be separated from the transfer substrate 400 by removing the sacrificial layer 420 later.

The light emitting element 330 that has subjected to a contact process may be dispersed in a fluid and assembled to the wiring substrate 310 while the sacrificial layer 420 is removed. In this regard, the light emitting element 330 may be assembled to the wiring substrate 310 by magnetic force and dielectric phoresis. A description of such a detailed process will be omitted.

The first contact layer 335 may be formed on the bottom surface of such a light emitting element 330. Hereinafter, a process of forming the first contact layer 335 will be described in detail.

First, in order to form the first contact layer, a photoresist layer 430 that opens the first surface (the bottom surface) of the first conductivity-type semiconductor layer 331 may be formed.

In a state in which the structure of the light emitting element 330 is locally attached to the transfer substrate 400 through the sacrificial layer 420 and the bonding layer 410, the photoresist layer 430 may be formed in a state in which a portion for forming the first contact layer on the first surface (the bottom surface) of the first conductivity-type semiconductor layer 331 is opened. Accordingly, as shown in FIG. 12, the photoresist layer 430 may be formed in contact with side surfaces of the structure of the light emitting element 330, the sacrificial layer 420, and the bonding layer 410.

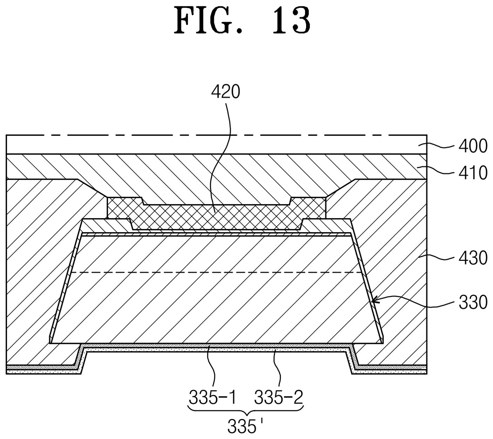

Thereafter, referring to FIG. 13, a metal layer 335' for forming the first contact layer including a first layer 335-1 and a second layer 335-2 may be continuously formed on the first surface (the bottom surface) of the first conductivity-type semiconductor layer 331.

Here, the first layer 335-1 may include a first metal forming an ohmic contact with the first conductivity-type semiconductor layer 331 described above and a second metal for diffusing the first metal. For example, the first metal and the second metal may form an alloy.

As an example, the first metal may include Ge, and the second metal may include Au. For example, the first layer 335-1 may be composed of an alloy of gold (Au) and germanium (Ge). In other words, the first layer 335-1 may include an AuGe material. For example, the first layer 335-1 may be made of AuGe. Such a first contact layer 335-1 may form the first contact layer 335 after a subsequent heat treatment process.

For example, the second layer 335-2 may include the second metal. In other words, the second layer 335-2 may include the Au material. For example, the second layer 335-2 may be made of Au.

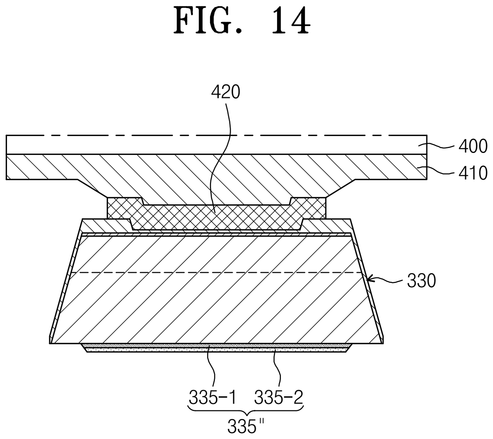

Next, referring to FIG. 14, the photoresist layer 430 may be removed. By this process, the first layer 335-1 and the second layer 335-2 are removed such that only a required area remains, thereby forming a metal structure 335" for forming the first contact layer.

Such a process may be referred to as a self-alignment process. Accordingly, additional processes and equipment for aligning the chip of the light emitting element 330 at a micrometer scale are unnecessary.

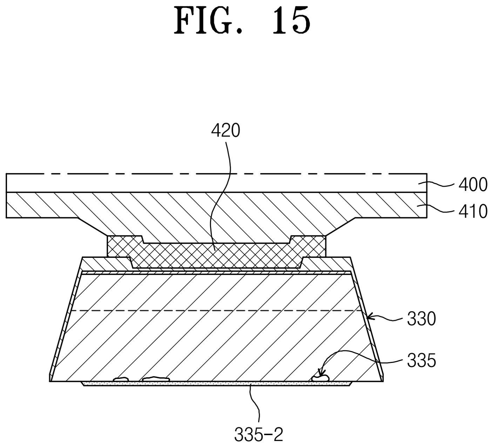

Thereafter, a heat treatment process may be performed. Through a heat treatment process, the first layer 335-1 may form a region (a diffused region) diffused into the first conductivity-type semiconductor layer 331. Referring to FIG. 15, such a diffused region may form an ohmic contact with the first conductivity-type semiconductor layer 331 to form the first contact layer 335. For example, a heat treatment process may be performed in a temperature range of 350°C to 450°C. As another example, a heat treatment process may be performed in a temperature range of 370°C to 410°C. Such a heat treatment temperature range may be more advantageous in terms of reflectance.

As described above, for example, the first contact layer 335 may be composed of an alloy of gold (Au) and germanium (Ge). In other words, the first contact layer 335 may include an AuGe material.

In this regard, Ge may be diffused into the first conductivity-type semiconductor layer 331 to form an ohmic contact with the first conductivity-type semiconductor layer 331. Au may help Ge to evenly spread onto the first surface without clumping.

FIG. 16 is a photograph capturing the first surfaces (the bottom surfaces) of the first conductivity-type semiconductor layers 331 of the circular light emitting elements. In the state of FIG. 16, the second layers 335-2 are shown.

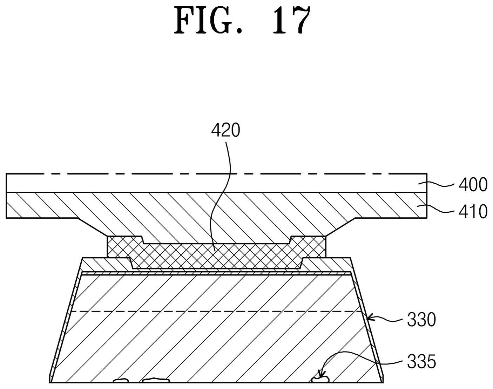

Thereafter, the second layers 335-2 may be removed. As such, when the second layer 335-2 is removed, a state as shown in FIG. 17 may be achieved.

As described above, after the Ge-diffused region is formed by a heat treatment process, the remaining layer (the second layer) may be removed. When an ohmic contact region is formed by Ge diffusion, the remaining region may be removed because it is disadvantageous in terms of reflection due to a high light absorption.

FIG. 18 is a photograph capturing the first surface (the bottom surface) of the first conductivity-type semiconductor layer 331 of the circular light emitting elements after the second layers 335-2 are removed. A portion shown as a stain in FIG. 18 may correspond to the Ge-diffused region. That is, in this portion, the first conductivity-type semiconductor layer 331 may form an ohmic contact.

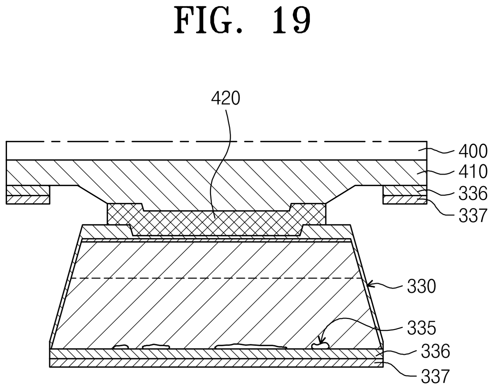

Referring to FIG. 19, after the second layer 335-2 is removed, a process of forming the reflective layer 336 on a surface from which the second layer 335-2 is removed may be performed.

Such a reflective layer 336 substantially covers the first surface (the bottom surface) of the first conductivity-type semiconductor layer 331, so that all portions other than the Ge-diffused region may be used for reflection.

Thereafter, as an exemplary embodiment, a process of forming the magnetic layer 337 on the reflective layer 336 may be performed.

In this state, when the sacrificial layer 420 is removed to separate the individual light emitting element 330, the light emitting elements 330 in the state shown in FIG. 10 may be manufactured.

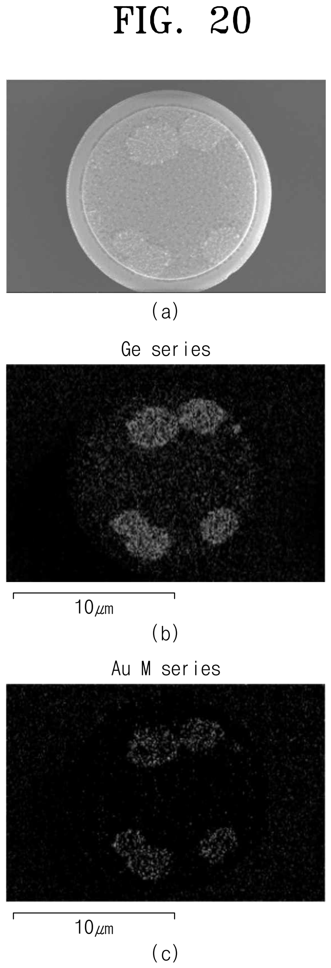

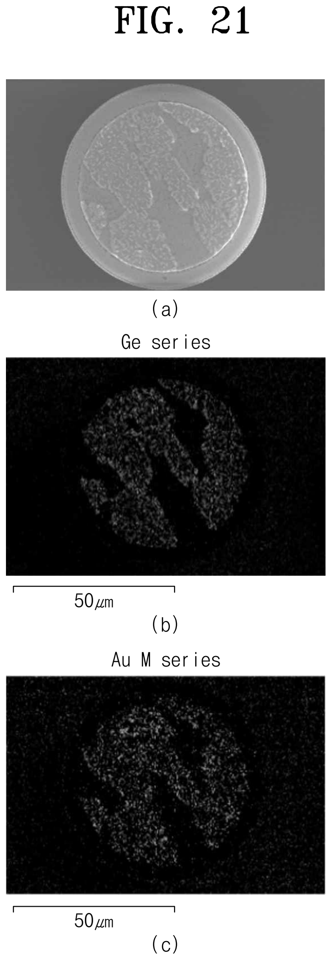

FIGS. 20 and 21 are photographs and analysis photographs showing examples in which the first contact layer is formed. FIGS. 20 and 21 show an ohmic contact region (e.g., a Ge-diffused region) according to a thickness change of the first layer 335-1 and the second layer 335-2.

For example, a diffused shape of Ge may vary depending on thicknesses and heat treatment temperatures of AuGe constituting the first layer 335-1. Accordingly, by adjusting thickness and heat treatment temperature, at least one of an area ratio of the ohmic contact region and reflectance of the light emitting element may be adjusted.

For example, AuGe constituting the first layer 335-1 may have a minimum thickness of 10nm in consideration of resistance characteristics. In an exemplary embodiment, AuGe forming the first layer 335-1 may be formed to have a thickness in a range of 10nm to 50nm. Accordingly, the first contact layer 335 may occupy an area of 5 to 20% of the total area of the first surface.

First, FIG. 20 shows a state in which the first layer 335-1 and the second layer 335-2 are formed with thicknesses of 30nm and 30nm, respectively.

Referring to (a) in FIG. 20, shown is a photograph capturing the first surface (the bottom surface) of the first conductivity-type semiconductor layer 331 of each circular light emitting element. (b) in FIG. 20 is an image showing a distribution of Ge atoms, and (c) in FIG. 20 is an image showing a distribution of Au atoms.

FIG. 21 shows a state in which the first layer 335-1 and the second layer 335-2 are formed with thicknesses of 50nm and 50nm, respectively.

Referring to (a) in FIG. 21, shown is a photograph capturing the first surface (the bottom surface) of the first conductivity-type semiconductor layer 331 of each circular light emitting element. (b) in FIG. 21 is an image showing a distribution of Ge atoms, and (c) in FIG. 21 is an image showing a distribution of Au atoms.

As described above, an area ratio of the ohmic contact region may vary as thicknesses of the first layer 335-1 and the second layer 335-2 increase. Accordingly, reflectance of the light emitting element may also vary.

FIG. 22 is a cross-sectional view showing a display device using a light emitting element according to an embodiment of the present disclosure.

Referring to FIG. 22, in the display device according to an embodiment of the present disclosure, the light emitting element 330 constituting a unit sub-pixel may be disposed on the wiring substrate 310 on which a first electrode 312 is disposed. The wiring substrate 310 may include the first electrode 312 disposed on a substrate 311.

In the wiring substrate 310, multiple first electrodes 312 may be positioned on the substrate 311. Such a first electrode 312 may be used as a wiring electrode. The first electrodes 312 may be partitioned and positioned on the substrate 311. In this regard, the wiring electrode may be used as a data electrode (a pixel electrode) or a scan electrode (a common electrode).

Although one light emitting element 330 is shown in FIG. 22, the light emitting element 330 forming three unit sub-pixels may constitute a unit pixel. In this regard, the light emitting element 330 may include a red light emitting element that emits red light, a green light emitting element that emits green light, and a blue light emitting element that emits blue light. Such unit pixels may be repeatedly provided on the wiring substrate 310.

Although not shown, the first electrode 312 disposed on the wiring substrate 310 may be connected to a TFT layer provided with a thin film transistor (TFT). The data electrode (the pixel electrode) may be connected to such a TFT layer. A detailed description thereof will be omitted.

A partition wall 320 for defining an assembly hole of the light emitting element may be positioned between the wiring substrate 310 and the light emitting element 330.

In an exemplary embodiment, at least one of the top surface and the bottom surface of the light emitting element 330 may have a circular shape. For example, the light emitting element 330 may have a cylindrical shape or a truncated cone shape.

In order to provide vertical selectivity when assembling the light emitting element 330, the lower area of the light emitting element 330 may be greater than the upper area. For example, the area of a surface of the light emitting element 330 close to the first contact layer 335 may be greater than the area of a surface far from the first contact layer 335.

In addition, the display device 300 may include a first connection electrode 340 that electrically connects the first electrode 312 with one side of the light emitting element 330. Such a first connection electrode 340 may be made of a metal having high electrical conductivity, such as Al, Mo, Cu, Ag, or Pt.

In an exemplary embodiment, one side of the light emitting element 330 to which the first connection electrode 340 is connected may be a side surface of the light emitting layer (active layer) 333 of the light emitting element 330. For example, the first connection electrode 340 may be laterally connected to a surface formed by the light emitting layer 333 of the light emitting element 330. Such a first connection electrode 340 may extend to a side surface of the first conductivity-type semiconductor layer 331 of the light emitting element 330 to form a side surface 342, thereby being electrically connected to the first conductivity-type semiconductor layer 331.

In this regard, aluminum (Al) used for the first connection electrode 340 and the reflective layer 336 of the light emitting element 330 may form an alloy. Thermal/electrical characteristics of the light emitting element and the display device may be improved by such alloy formation.

As described above, the first connection electrode 340 may include the side surface 342 positioned on the side surface of the light emitting element 330 and a bottom surface 343 positioned on a top surface of the seating layer 320.

Referring to FIG. 22, the first connection electrode 340 may be provided on both sides of the light emitting element 330. In some cases, the first connection electrode 340 may be provided to cover the side surface of the light emitting element 330.

In addition, such a first connection electrode 340 may be electrically connected to the magnetic layer 337 of the light emitting element 330. In order to increase the adhesive force of at least one of the magnetic layer 337 and the first connection electrode 340, a metal such as Cr and/or Ti may be added.

The passivation layer 338 may be positioned outside a portion of the side surface of the light emitting element 330 to which the first connection electrode 340 is connected. As described above, the passivation layer 338 may be positioned on an outer side of the light emitting element 330, and the first connection electrode 340 may be positioned beneath the passivation layer 338. Such a passivation layer 338 may protect an outer surface of the light emitting element 330.

A planarization layer 350 may be positioned on side portions of the first connection electrode 340 and the light emitting element 330. The planarization layer 350 may cover the first connection electrode 340 and the light emitting element 330. An upper side of the planarization layer 350 may have a vertical level that is flush with an upper side of the light emitting element 330, or a vertical level higher than that of the upper side of the light emitting element 330.

In this regard, the second conductivity-type semiconductor layer 332 in the upper side of the light emitting element 330 may be exposed. For example, even when the upper side of the planarization layer 350 has a vertical level higher than that of the upper side of the light emitting element 330, the second conductivity-type semiconductor layer 332 of the light emitting element 330 may be exposed.

In addition, a second connection electrode 361 positioned on the planarization layer 350 and electrically connected to an opposite side of the light emitting element 330 may be provided. For example, such a second connection electrode 361 may include a transparent electrode such as ITO. Accordingly, light emitted from the light emitting element 330 may pass through the second connection electrode 361 and be emitted to the outside.

As described above, the first electrode 312 and the second electrode 360 may be used as wiring electrodes. For example, the first electrode 312 may function as the data electrode (the pixel electrode), and the second electrode 360 may function as the scan electrode (the common electrode).

Referring to FIG. 22, the second connection electrode 361 may be partially located on the light emitting element 330. In some cases, such a second connection electrode 361 may be connected to another second connection electrode by the second electrode 360.

The foregoing description is merely illustrative of the present invention, and various modifications and variations may be made by those skilled in the art to which the present invention pertains without departing from the essential features of the present invention.

Accordingly, the embodiments disclosed herein are intended to illustrate the present invention and not to limit the present invention, and the scope of the present invention is not limited by such embodiments.

The scope of protection of the present invention shall be determined by the appended claims, and all modifications and equivalents falling within the scope of the claims are intended to be included within the scope of the present invention.

### [Industrial Availability]

According to the present invention, a semiconductor light-emitting device such as a micro-LED and a display device using the same can be provided.

## Claims

1. A light emitting element comprising:
a first conductivity-type semiconductor layer;
a second conductivity-type semiconductor layer;
an active layer disposed between the first conductivity-type semiconductor layer and the second conductivity-type semiconductor layer;
a first contact layer having at least a portion electrically connected to a first surface of the first conductivity-type semiconductor layer in a discontinous manner; and
a reflective layer disposed on the first contact layer.

2. The light emitting element of claim 1, wherein the first contact layer forms an ohmic contact with the first conductivity-type semiconductor layer at a portion that is electrically connected to the first surface in a discontinous manner.

3. The light emitting element of claim 1, wherein the ohmic contact is formed by diffusion of at least a portion of the first contact layer into the first conductivity-type semiconductor layer.

4. The light emitting element of claim 1, wherein the first contact layer includes:
a first metal forming an ohmic contact with the first conductivity-type semiconductor layer; and
a second metal for diffusing the first metal.

5. The light emitting element of claim 4, wherein the first metal and the second metal form an alloy.

6. The light emitting element of claim 4, wherein the first metal includes a region diffused into the first conductivity-type semiconductor layer.

7. The light emitting element of claim 4, wherein an interface exists between the first contact layer and the reflective layer.

8. The light emitting element of claim 7, wherein the reflective layer is a single metal layer including Ag.

9. The light emitting element of claim 4, wherein the first metal includes Ge, and the second metal includes Au.

10. The light emitting element of claim 1, further comprising a magnetic layer disposed on the reflective layer.

11. The light emitting element of claim 1, further comprising a second contact layer positioned on a second surface opposite to the first surface with respect to the active layer, and electrically connected to the first conductivity-type semiconductor layer.

12. The light emitting element of claim 1, wherein the first contact layer occupies an area of 5 to 20% of a total area of the first surface.

13. A method for manufacturing a light emitting element including a semiconductor layer including a first conductivity-type semiconductor layer, a second conductivity-type semiconductor layer, and an active layer disposed between the first conductivity-type semiconductor layer and the second conductivity-type semiconductor layer, the method comprising:
forming a first contact layer on the first conductivity-type semiconductor layer; and
forming a reflective layer on a first metal layer,
wherein the forming of the first contact layer includes:
forming a first layer where a first metal and a second metal form an alloy on the first conductivity-type semiconductor layer;
forming a second layer including the second metal on the first layer;
performing heat treatment; and
removing the second layer.

14. The method of claim 13, wherein the forming of the first contact layer includes:
forming a photoresist layer opening a first surface of the first conductivity-type semiconductor layer;
continuously forming the first layer and the second layer on the first surface; and
removing the photoresist.

15. The method of claim 13, wherein the forming of the first contact layer is performed while the second conductivity-type semiconductor layer is attached to a transfer substrate through a sacrificial layer.

16. The method of claim 13, wherein the first metal includes Ge, and the second metal includes Au.

17. The method of claim 13, further comprising forming a reflective layer on a surface from which the second layer has been removed.

18. The method of claim 17, wherein the reflective layer is a single metal layer including Ag.

19. The method of claim 13, further comprising forming a magnetic layer on the reflective layer.

20. A display device using a semiconductor light emitting element, the display device comprising:
a wiring substrate where a first electrode is disposed;
a light emitting element including a semiconductor layer disposed on the wiring substrate to form a unit sub-pixel;
a first connection electrode electrically connecting the first electrode to one side of the semiconductor layer of the light emitting element;
a planarization layer covering the light emitting element and the first connection electrode; and
a second connection electrode positioned on the planarization layer and electrically connected to an opposite side of the semiconductor layer of the light emitting element,
wherein the light emitting element includes:
a first contact layer having at least a portion electrically connected to a first surface of the semiconductor layer in a discontinous manner; and
a reflective layer disposed on the first contact layer.
